# EUROPEAN PATENT APPLICATION

(11) **EP 0 851 506 A2**
(43) Date of publication of application: **01.07.1998**
(21) Application number: 97310571.1
(22) Date of filing: 24.12.1997
(51) Int. Cl.: H01L 29/12

(54) **Semiconductor device having quantum box and method of fabricating the same**

(30) Priority: 27.12.1996 JP 350538/96
(71) Applicant: SANYO ELECTRIC CO. LTD, Moriguchi-shi, Osaka-fu 570 (JP)
(72) Inventor: Matsushita, Shigeharu, Katano-shi, Osaka-fu 576 (JP); Matsumura, Kohji, Hirakata-shi, Osaka-fu 573 (JP); Fujii, Emi, Ikoma-gun, Nara-ken 636 (JP)
(74) Representative: Calderbank, Thomas Roger

(57) **Abstract**

A semiconductor device comprises a channel layer where electrons transit and a barrier layer formed on the channel layer, and a plurality of quantum boxes are provided in the barrier layer. The plurality of quantum boxes form a plurality of quantum box strings which are perpendicular to the electron transition direction in the channel region of the channel layer, and the plurality of quantum box strings are arranged at prescribed intervals in a direction parallel to the electron transition direction in the channel region. Alternatively, the channel region is formed in the shape of a thin line parallel to the electron transition direction in the channel region, and the plurality of quantum boxes are arranged in a line at prescribed intervals along the thin-line shaped channel region. A process of fabricating the quantum boxes comprises steps of forming a pattern having a plane orientation readily allowing self-organized formation on a surface of a first semiconductor having a plane orientation hardly allowing self-organized formation, and selectively forming quantum boxes composed of a second semiconductor on the pattern in a self-organized manner by forming the second semiconductor on the surface of the first semiconductor.

## Description

This application is related to copending application US Serial Number 08/561,124, field November 20, 1995, commonly assigned with the present invention.

The present invention relates to a semiconductor device and a method of fabricating the same, and more particularly, it relates to a semiconductor device having quantum boxes which can be implemented with higher integration and is operable at a low voltage, and a method of fabricating the same.

A semiconductor memory element substituting for a memory device having a mechanical part such as a hard disk is indispensable for miniaturizing a portable information device, reducing the power consumption and improving the reliability. The so-called flash memory comprising a floating gate field-effect transistor (FG-FET) is actively developed for such application at present. However, an FG-FET disadvantageously requires a high gate voltage (at least 10 V) for writing/erasing data, and can write/erase data by only a small number of times (about 10⁵ times). When the element is further refined and implemented with higher integration such that the gate length is not more than 0.1 µm, further, the element cannot stably operate due to reduction of the carrier number and appearance of a quantum effect.

Due to mainly theoretical researches, it is currently known that a semiconductor device such as a semiconductor electronic element which can be implemented with higher integration and is operable at a low voltage or a semiconductor light emitting device which can operate in high efficiency with a low current can be fabricated through a hyperfine structure of quantum boxes or the like.

For example, Japanese Patent Laying-Open Gazette No. 8-148669 (1996) proposes a semiconductor device provided with quantum boxes in the vicinity of a channel region where electrons transit. This semiconductor device is a semiconductor memory element employing quantum boxes in place of the floating gate of the aforementioned FG-FET, for causing a write/erase state of a memory in correspondence to presence/absence of electrons in the quantum boxes.

The term "quantum box" indicates a structure which can three-dimensionally confine electrons or holes in a region smaller than the de Bloglie wavelength of the electrons or holes in a semiconductor. Throughout the specification, the term "quantum box" indicates a structure which can confine electrons or holes in a size of not more than 1000 Å entirely in three-dimensional directions X, Y and Z which are perpendicular to each other.

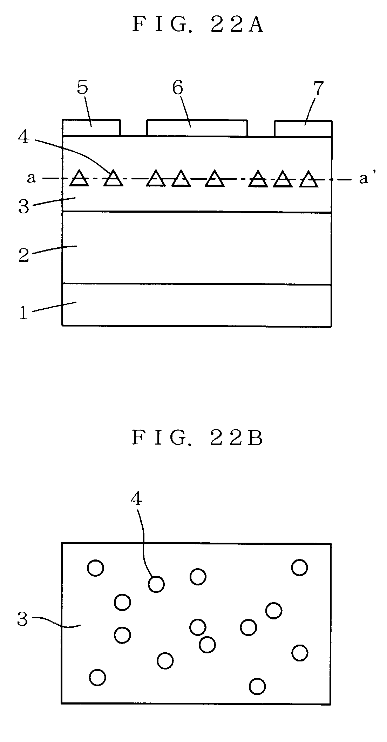

The conventional semiconductor device described in the aforementioned gazette is now described with reference to Figs. 22A and 22B. Fig. 22A is a typical sectional view showing the structure of the conventional semiconductor device provided with quantum boxes in the vicinity of a channel where electrons transit, and Fig. 22B is a sectional view taken along the line a - a' in Fig. 22A (illustrating the section taken along the one-dot chain line a - a' in Fig. 22A as viewed from above).

Referring to Fig. 22A, a channel layer 2 of 8000 Å in thickness composed of undoped GaAs, and a barrier layer 3 of 350 Å in thickness composed of N-Al₀₋₃Ga_{0.7}As doped with Si with a doping concentration of 10¹⁸ cm⁻³ are stacked on a substrate 1 composed of semi-insulating GaAs. Quantum boxes 4, composed of InAs, of not more than 500 Å in size are buried in the barrier layer 3. Ohmic source and drain electrodes 5 and 7 are formed on the barrier layer 3 at a prescribed interval. Further, a Schottky gate electrode 6 is formed on the barrier layer 3 between the source and drain electrodes 5 and 7. In this conventional semiconductor device, the quantum boxes 4 are distributed at random on the same plane, as shown in Fig. 22B.

The operation of the aforementioned conventional semiconductor device is now described with reference to Fig. 22A. When a voltage is applied between the source and drain electrodes 5 and 7, electrons enter the channel layer 2 from the source electrode 5 through the barrier layer 3 and pass through a channel region in the channel layer 2 opposed to the gate electrode 6, to be outputted from the drain electrode 7 through the barrier layer 3. A source-to-drain current flows in this state, which is referred to as an erase state of the element.

When a positive pulse voltage is applied to the gate electrode 6 in the aforementioned erase state, the electrons move into the quantum boxes 4 from the channel region through the barrier layer 3, to be confined therein and held as such. At this time, the source-to-drain current reduces due to reduction of the electron concentration in the channel region opposed to the gate electrode 6. This state is referred to as a write state of the element.

When a negative pulse voltage is applied to the gate electrode 6 in the aforementioned write state, the electrons confined in the quantum boxes 4 are returned to the channel region opposed to the gate electrode 6 through the barrier layer 3 again, to be in the same state as the aforementioned erase state.

Thus, the aforementioned conventional semiconductor device is a 1-bit digital memory element which enters two states, i.e., erase and write states in correspondence to presence/absence of electrons in the quantum boxes. Namely, the output of this semiconductor device changes in a binary manner. As compared with the FG-FET, the conventional semiconductor device can advantageously write/erase data with a smaller gate voltage (about 1 V) thereby increasing the number of writable/erasable times (at least 10⁵ times) and is operable even if refined to not more than 0.1 µm.

However, the aforementioned conventional semiconductor device is a 1-bit element having two states of write and erase states similarly to the FG-FET, since the quantum boxes 4 are present at random, as hereinabove described. In order to implement the element with higher integration following an increased storage capacity, therefore, the semiconductor device must be refined similarly to the FG-FET. In case of fabricating such a conventional semiconductor device with refinement to not more than 0.1 µm, for example, the fabrication cost is increased or the yield is reduced disadvantageously.

Two types of conventional methods of fabricating quantum boxes are now described. In general, self-organized formation and selective growth are employed for forming quantum boxes.

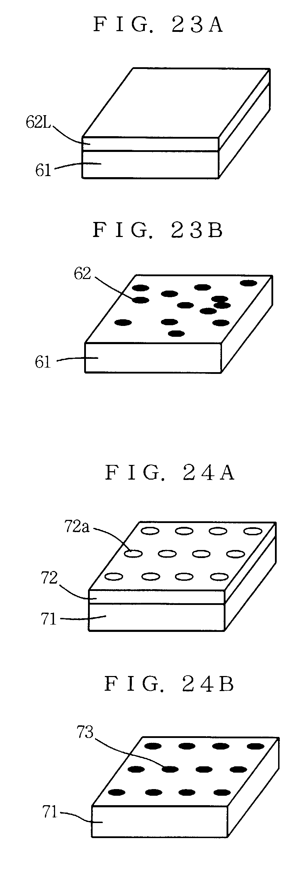

First, self-organized formation of quantum boxes is described. Figs. 23A and 23B illustrate a method of fabricating quantum boxes by self-organized formation.

Referring to Fig. 23A, an InAs layer 62L of about 2.5 molecular layers in thickness is formed on a GaAs layer 61. The lattice constant of InAs is larger than that of GaAs, and hence internal stress results in the InAs layer 62L formed on the GaAs layer 61. The InAs layer 62L is formed by epitaxy such as molecular beam epitaxy (MBE), metal-organic chemical vapor deposition (MOCVD) or chemical beam epitaxy (CBE).

When the InAs layer 62L is deposited in excess of about 2.5 molecular layers, the lamellar InAs layer 62L having two-dimensional spreading is transformed into quantum boxes 62 of about 150 Å in diameter, which are three-dimensional masses, as shown in Fig. 23B. This is because the internal stress so increases that the two-dimensional layer structure cannot be held if the thickness of the InAs layer 62L exceeds about 2.5 molecular layers.

The aforementioned quantum box forming method is known as self-organized formation of quantum boxes. The feature of the self-organized formation of quantum boxes resides in that hyperfine quantum boxes of not more than several 100 Å can be formed with no requirement for a specific technique of refinement.

In the self-organized formation of quantum boxes, however, the respective quantum boxes are disadvantageously distributed at random due to uncontrollable forming positions and sizes thereof.

The selective growth of quantum boxes is now described. Figs. 24A and 24B illustrate a method of fabricating quantum boxes by selective growth.

Referring to Fig. 24A, a mask 72 formed of an Si oxide film or an Si nitride film is formed on a GaAs layer 71. The mask 72 is provided with cylindrical opening patterns 72a of not more than 1000 Å in diameter, in a depth reaching a surface of the GaAs layer 71. The opening patterns 72a are formed by electron beam exposure (EB exposure) and reactive ion etching (RIE) or the like.

When an InAs layer is grown from above the mask 72 by the aforementioned epitaxy, InAs layers are selectively grown on surface parts of the GaAs layer 71 exposed on the bottoms of the opening patterns 72 since no InAs is grown on the mask 72.

Then, the mask 72 is removed by wet etching, whereby a structure provided with quantum boxes 73 composed of InAs appears on the GaAs layer 71, as shown in Fig. 24B.

This method is known as selective growth of quantum boxes, and its feature resides in that the sizes and the forming positions of the quantum boxes are controllable.

However, the selective growth of quantum boxes has such disadvantages that hyper-refinement to not more than 1000 Å is required for forming mask patterns substantially identical in size to the quantum boxes, Si atoms contained in the mask 72 are self-doped in the quantum boxes 73 as impurities, and defects are readily caused on the GaAs layer 71 and the quantum boxes 73 in the aforementioned step of removing the mask 72.

An object of the present invention is to provide a semiconductor device which can increase its storage capacity with no requirement for hyper-refinement.

Another object of the present invention is to provide a semiconductor memory device which may store a number of bits and increase its storage capacity without increasing the degree of integration.

Still another object of the present invention is to provide a method of fabricating a semiconductor device which may position-controllably form quantum boxes without employing a technique of hyper-refinement or a mask for selective growth.

A further object of the present invention is to provide a method of fabricating a semiconductor device which may control positions for forming quantum boxes without employing lithography using ultraviolet rays, X-rays, electron beams or ion beams.

A semiconductor device according to an aspect of the present invention comprises a channel region where carriers transit and a plurality of quantum boxes provided in the vicinity of the channel region through a potential barrier for storing carriers. The plurality of quantum boxes are arranged at prescribed intervals in a direction parallel to the carrier transition direction in the channel region.

The semiconductor device having such a structure can change a plurality of states including a state storing no carriers in the plurality of quantum boxes, that storing carriers in some of the plurality of quantum boxes and that storing carriers in all of the plurality of quantum boxes stepwise in response to the value of an applied voltage.

In particular, no other quantum boxes are preferably present between the plurality of quantum boxes. Thus, no intermediate state appears in addition to the aforementioned plurality of states, whereby the plurality of states can be reliably changed stepwise with no development of an intermediate state.

The plurality of quantum boxes may form a plurality of quantum box strings which are perpendicular to the carrier transition direction in the channel region, so that the plurality of quantum box strings are arranged at the aforementioned prescribed intervals in the direction parallel to the carrier transition direction in the channel region. Thus, the number of carriers stored in the quantum boxes is increased, whereby the change between the plurality of states can be increased.

In particular, the plurality of quantum box strings are preferably parallel to each other. If the plurality of quantum box strings are not parallel to each other, the intervals between the quantum box strings are partially narrowed to reduce the difference between the aforementioned plurality of states, leading to reduction of the change between the plurality of states. If the plurality of quantum box strings are parallel to each other, on the other hand, the change between the plurality of states is prevented from reduction.

The channel region may be formed in the shape of a thin line which is parallel to the carrier transition direction in the channel region, so that the plurality of quantum boxes are arranged at the aforementioned prescribed intervals in a line along the thin-line shaped channel region. Thus, refinement and high integration of the semiconductor device are enabled.

The semiconductor device may further comprise first and second electrodes for supplying carriers to the channel region. Thus, a digital current output can be extracted by feeding a current to the channel region.

The semiconductor device may further comprise a third electrode for generating an electric field between the channel region and the plurality of quantum boxes. Thus, it is possible to store carriers in the quantum boxes or vacate the quantum boxes by applying a voltage to the third electrode.

A semiconductor device according to another aspect of the present invention comprises a channel layer having a channel region where carriers transit in a direction parallel to a layer interface, a barrier layer which is formed on the channel layer having a larger forbidden bandwidth than the channel layer and a plurality of quantum boxes which are buried in the barrier layer having a smaller forbidden bandwidth than the barrier layer. The plurality of quantum boxes are arranged at prescribed intervals in a direction parallel to the carrier transition direction in the channel region.

Due to the structure, presence/absence of carriers in the plurality of quantum boxes can be detected through change of a current flowing in the channel region.

The plurality of quantum boxes may form a plurality of quantum box strings which are perpendicular to the carrier transition direction in the channel region, so that the quantum box strings are arranged at the aforementioned prescribed intervals in the direction perpendicular to the carrier transition direction in the channel region. Thus, the number of carriers stored in the quantum boxes increases, whereby change between a plurality of states can be increased.

The channel region may be formed in the shape of a thin line which is parallel to the carrier transition direction in the channel region, so that the plurality of quantum boxes are arranged in a thin-line shaped region of the barrier layer corresponding to the thin-line shaped channel region at prescribed intervals in a line along the carrier transition direction in the channel region. Thus, refinement and high integration of the semiconductor device are enabled.

The channel layer may be formed of an undoped semiconductor, the barrier layer may be formed of one conductivity type semiconductor or insulator, and the plurality of quantum boxes may be composed of an undoped semiconductor or metal.

The semiconductor device may further comprise first and second electrodes for supplying carriers to the channel region. Thus, a digital current output can be extracted by feeding a current to the channel region.

The semiconductor device may further comprise a third electrode for generating an electric field between the channel region and the plurality of quantum boxes. Thus, it is possible to store carriers in the quantum boxes or vacate the quantum boxes by applying a voltage to the third electrode.

An output may be extracted as multivalued logic from the first and second electrodes in correspondence to presence/absence of carriers in the plurality of quantum boxes. Thus, the current output can be digitally changed.

The channel layer may be composed of a GaAs, InGaAs or SiGe semiconductor, the barrier layer may be composed of an AlGaAs, InAlAs or Si semiconductor, and the plurality of quantum boxes may be composed of an InAs or Ge semiconductor.

The semiconductor device may further comprise a substrate having a slightly inclined surface inclined from the basic plane orientation, so that the channel layer is formed on the slightly inclined surface of the substrate. In this case, the plurality of quantum boxes can align substantially in parallel with each other at regular intervals along steps on surfaces of the channel layer and the barrier layer successively formed on the slightly inclined surface of the substrate.

A semiconductor device according to still another aspect of the present invention comprises a channel layer having a channel region where carriers transit in a direction parallel to a layer interface, a barrier layer formed on the channel layer having a larger forbidden bandwidth than the channel layer and a plurality of quantum boxes buried in the channel layer having a smaller forbidden bandwidth than the channel layer. The plurality of quantum boxes are arranged at prescribed intervals in a direction parallel to the carrier transition direction in the channel region.

Due to this structure, presence/absence of carriers in the plurality of quantum boxes can be detected by change of a current flowing in the channel region.

The plurality of quantum boxes may form a plurality of quantum box strings which are perpendicular to the carrier transition direction in the channel region, so that the plurality of quantum box strings are arranged at the aforementioned prescribed intervals in the direction parallel to the carrier transition direction in the channel region. Thus, the number of carriers stored in the quantum boxes is increased, whereby change between a plurality of states can be increased.

The channel region may be formed in the shape of a thin line which is parallel to the carrier transition direction in the channel region, so that the plurality of quantum boxes are arranged at the aforementioned prescribed intervals in a line along a direction parallel to the carrier transition direction in the thin-line shaped channel region. Thus, refinement and high integration of the semiconductor device are enabled.

In particular, the plurality of quantum box strings are preferably parallel to each other. In this case, change between a plurality of states is prevented from reduction.

The channel layer may be formed of an undoped semiconductor, the barrier layer may be formed of one conductivity type semiconductor or insulator, and the plurality of quantum boxes may be composed of an undoped semiconductor or metal.

The semiconductor device may further comprise first and second electrodes for supplying carriers to the channel region. Thus, a digital current output can be extracted by feeding a current to the channel region.

The semiconductor device may further comprise a third electrode for generating an electric field between the channel region and the plurality of quantum boxes. Thus, it is possible to store carriers in the quantum boxes or vacate the quantum boxes by applying a voltage to the third electrode.

An output may be extracted as multivalued logic from the first and second electrodes in correspondence to presence/absence of carriers in the plurality of quantum boxes. Thus, the current output can be digitally changed.

The channel layer may be formed of a GaAs, InGaAs or SiGe semiconductor, the barrier layer may be formed of an AlGaAs, InAlAs or Si semiconductor, and the plurality of quantum boxes may be composed of an InAs or Ge semiconductor.

The semiconductor device may further comprise a substrate having a slightly inclined surface inclined from the basic plane orientation, so that the channel layer is formed on the slightly inclined surface of the substrate. In this case, the plurality of quantum boxes can align substantially in parallel with each other at regular intervals along a step on a surface of the channel layer formed on the slightly inclined surface of the substrate.

A semiconductor memory device according to a further aspect of the present invention comprises a channel region where carriers transit, a plurality of quantum boxes provided in the vicinity of the channel region through a potential barrier for storing carriers and first and second electrodes for supplying carriers to the channel region. The plurality of quantum boxes are arranged at prescribed intervals in a direction parallel to the carrier transition direction in the channel region.

This semiconductor device can change a plurality of states including a state storing no carriers in the plurality of quantum boxes, that storing carriers in some of the plurality of quantum boxes and that storing carriers in all of the plurality of quantum boxes stepwise in response to the value of an applied voltage. Thus, a single element can store a number of bits, and its storage capacity can be increased without increasing the degree of integration.

An output may be extracted as multivalued logic from the first and second electrodes in correspondence to presence/absence of carriers in the plurality of quantum boxes. Thus, a current output can be digitally changed.

A method of fabricating a semiconductor device comprising a channel region where carriers transit and a plurality of quantum boxes provided in the vicinity of the channel region through a potential barrier for storing carriers according to a further aspect of the present invention comprises steps of forming a single or plurality of semiconductor layers including the channel region, interrupting the formation of the single or plurality of semiconductor layers, forming a plurality of quantum boxes on a surface of the single or plurality of semiconductor layers appearing during the interruption at prescribed intervals in a direction parallel to the carrier transition direction in the channel region, and further forming a semiconductor layer on the single or plurality of semiconductor layers to bury the plurality of quantum boxes therein.

According to this method, no hyper-refinement is required for forming the quantum boxes. Further, the semiconductor device fabricated by this method can change a plurality of states including a state storing no carriers in the plurality of quantum boxes, that storing carriers in some of the plurality of quantum boxes and that storing carriers in all of the plurality of quantum boxes stepwise in response to the value of an applied voltage.

The method of fabricating a semiconductor device may further comprise a step of forming a slightly inclined surface having a plane orientation inclined from the basic crystal orientation on a surface of a substrate, and the step of forming the single or plurality of semiconductor layers may include a step of forming the single or plurality of semiconductor layers including the channel region on the slightly inclined surface of the substrate.

According to this method, the plurality of quantum boxes can align substantially in parallel with each other at regular intervals along a surface step on the surface of the semiconductor layer appearing during the aforementioned interruption.

The step of forming the plurality of quantum boxes may include a step of forming the plurality of quantum boxes by self-organized formation, so that the plurality of quantum boxes align along a surface step appearing on the surface of the semiconductor layer(s) substantially parallel to each other at regular intervals.

The single or plurality of semiconductor layers may include a first semiconductor having a surface having a plane orientation hardly allowing self-organized formation, and the step of forming a plurality of quantum boxes may include steps of forming a plurality of patterns having a plane orientation readily allowing self-organized formation on the surface of the first semiconductor and forming a plurality of quantum boxes composed of a second semiconductor on the self-organized manner in a self-organized manner by forming the second semiconductor on the surface of the first semiconductor.

In this case, the positions for forming the plurality of quantum boxes depend on the positions of the plurality of patterns. Therefore, it is possible to form position-controlled fine quantum boxes without employing hyper-refinement or a mask for selective growth.

A method of fabricating a semiconductor device comprising a channel region where carriers transit, a plurality of quantum boxes provided in the vicinity of the channel region through a potential region for storing carriers and a buried layer formed of a semiconductor or insulator having the plurality of quantum boxes buried therein according to a further aspect of the present invention comprises steps of forming a thin-line shaped region by working at least one of the channel region and the buried layer into the shape of a thin line, forming the plurality of quantum boxes on the thin-line region at prescribed intervals, and burying the plurality of quantum boxes in the semiconductor or insulator.

This method may further comprise a step of forming an electrode to be opposed to the plurality of quantum boxes. In this case, the electrode opposed to the plurality of quantum boxes can be readily formed with reference to the thin-line shaped region.

The single or plurality of semiconductor layers may include a first semiconductor having a surface having a plane orientation hardly allowing self-organized formation, and the step of forming the plurality of quantum boxes may include steps of forming a plurality of patterns having a plane orientation readily allowing self-organized formation on the surface of the first semiconductor and forming a plurality of quantum boxes composed of a second semiconductor on the plurality of patterns in a self-organized manner by forming the second semiconductor on the surface of the first semiconductor.

In this case, the positions for forming the plurality of quantum boxes depend on the positions of the plurality of patterns. Therefore, it is possible to form position-controlled fine quantum boxes without employing hyper-refinement or a mask for selective growth.

A method of fabricating a semiconductor device according to a further aspect of the present invention comprises steps of forming a slightly inclined surface having a plane orientation inclined from the basic crystal orientation on a surface of a substrate, forming a semiconductor layer on the slightly inclined surface of the substrate, interrupting the formation of the semiconductor layer, and forming a plurality of quantum boxes by self-organized formation so that the plurality of quantum boxes align on a surface step appearing on a surface of the semiconductor layer during the interruption.

According to this method, it is possible to align the plurality of quantum boxes substantially in parallel with each other at regular intervals along the surface step on the surface of the semiconductor layer during the aforementioned interruption.

A method of fabricating a semiconductor device according to a further aspect of the present invention comprises steps of forming a pattern having a plane orientation readily allowing self-organized formation on a surface of a first semiconductor having a plane orientation hardly allowing self-organized formation, and forming a quantum box composed of a second semiconductor on the pattern in a self-organized manner by forming the second semiconductor on the surface of the first semiconductor.

When this method is employed, the position for forming the quantum box depends on the position of the pattern. Therefore, it is possible to form a position-controlled fine quantum box without employing hyper-refinement or a mask for selective growth.

The step of forming the pattern may include a step of employing natural lithography. Thus, it is possible to form the aforementioned pattern without employing lithography utilizing ultraviolet rays, X-rays, electron beams, ion beams or the like.

The natural lithography may include steps of applying a polymer compound to the aforementioned surface of the first semiconductor thereby arranging molecular balls of the polymer compound on the aforementioned surface of the first semiconductor, and etching the first semiconductor through the molecular balls of the polymer compound serving as masks.

The plane orientation hardly allowing self-organized formation may be the (221) plane, and the plane orientation readily allowing self-organized formation may be a plane different from the (221) plane.

The first semiconductor may include a single or plurality of semiconductors selected from a group of GaAs, AlGaAs and InGaAs semiconductors, and the quantum boxes may include a single or plurality of semiconductors selected from a group of InAs, InGaAs, InSb and GaSb semiconductors.

The foregoing and other objects, features, aspects and advantages of the present invention will become more apparent from the following detailed description of the present invention when taken in conjunction with the accompanying drawings.
Fig. 1A is a typical sectional view showing the structure of a semiconductor device according to a first embodiment of the present invention;
Fig. 1B is a sectional view of the semiconductor device taken along the line a - a' in Fig. 1A;
Fig. 2 is a typical sectional view showing a first step of a method of fabricating the semiconductor device according to the first embodiment;
Fig. 3 is a typical sectional view showing a second step of the method of fabricating the semiconductor device according to the first embodiment;
Fig. 4 is a typical sectional view showing a third step of the method of fabricating the semiconductor device according to the first embodiment;
Fig. 5 is a typical sectional view showing a fourth step of the method of fabricating the semiconductor device according to the first embodiment;
Fig. 6 is a typical sectional view showing a fifth step of the method of fabricating the semiconductor device according to the first embodiment;
Fig. 7 is a typical sectional view showing a sixth step of the method of fabricating the semiconductor device according to the first embodiment;
Fig. 8 is a typical sectional view showing a seventh step of the method of fabricating the semiconductor device according to the first embodiment;
Fig. 9 illustrates the operation of the semiconductor device according to the first embodiment;
Fig. 10 illustrates the current-voltage characteristics of the semiconductor device according to the first embodiment;
Fig. 11A is a typical sectional view showing the structure of a semiconductor device according to a second embodiment of the present invention;
Fig. 11B is a sectional view taken along the line a - a' in Fig. 11A;
Figs. 12A, 12B, 12C, 12D and 12E are typical sectional views showing first to fifth steps of a method of fabricating the semiconductor device according to the second embodiment respectively;
Fig. 13A is a typical sectional view showing the structure of a semiconductor device according to a third embodiment of the present invention;
Fig. 13B is a sectional view of the semiconductor device taken along the line a - a' in Fig. 13A;
Fig. 14A is a typical sectional view showing a first step of a method of fabricating the semiconductor device according to the third embodiment;
Fig. 14B is a top plan view of the semiconductor device shown in Fig. 14A as viewed along arrow B;
Fig. 14C is a side elevational view of the semiconductor device shown in Fig. 14A as viewed along arrow C;
Figs. 15A and 15B are a typical sectional view and a plan view showing a second step of the method of fabricating the semiconductor device according to the third embodiment respectively;
Figs. 16A and 16B are a typical sectional view and a plan view showing a third step of the method of fabricating the semiconductor device according to the third embodiment respectively;
Figs. 17A and 17B are a typical sectional view and a plan view showing a fourth step of the method of fabricating the semiconductor device according to the third embodiment respectively;
Figs. 18A and 18B are a typical sectional view and a plan view showing a fifth step of the method of fabricating the semiconductor device according to the third embodiment respectively;
Fig. 19 illustrates the operation of the semiconductor device according to the third embodiment;
Figs. 20A, 20B, 20C and 20D are perspective views showing first to fourth steps of a method of fabricating quantum boxes according to a fourth embodiment of the present invention respectively;
Figs. 21A and 21B are plan views showing first and second steps of a method of fabricating quantum boxes according to a fifth embodiment of the present invention respectively;
Fig. 22A is a typical sectional view showing the structure of a conventional semiconductor device;
Fig. 22B is a sectional view of the conventional semiconductor device taken along the line a - a' in Fig. 22A;
Fig. 23A is a perspective view showing a first step of a conventional method of fabricating quantum boxes by self-organized formation;
Fig. 23B is a perspective view showing a second step of the conventional method of fabricating quantum boxes by self-organized formation;
Fig. 24A is a perspective view showing a first step of a conventional method of fabricating quantum boxes by selective growth; and
Fig. 24B is a perspective view showing a second step of the conventional method of fabricating quantum boxes by selective growth.

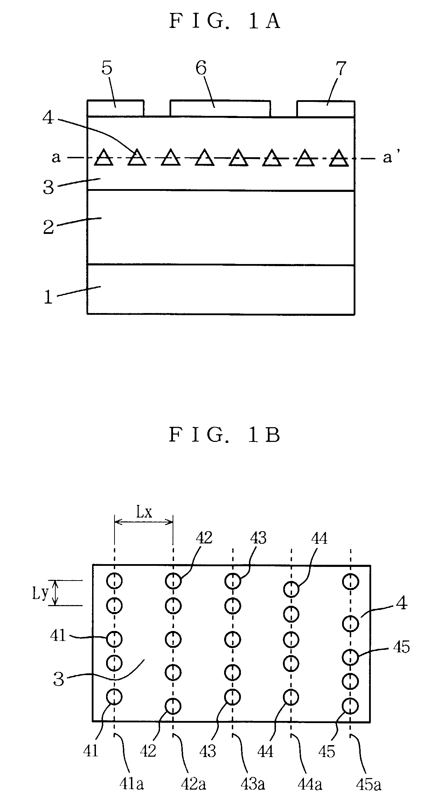

The structure of a semiconductor device according to a first embodiment of the present invention is now described with reference to Figs. 1A and 1B, followed by description of a method of fabricating this semiconductor device.

Fig. 1A is a typical sectional view showing the structure of the semiconductor device according to the first embodiment, and Fig. 1B is a sectional view of the semiconductor device taken along the line a - a' in Fig. 1A (showing a section along the one-dot chain line a - a' as viewed from above).

Referring to Fig. 1A, a channel layer 2 of 8000 Å in thickness composed of undoped GaAs and a barrier layer 3 of 350 Å in thickness composed of N-Al_{0.3}Ga_{0.7}As doped with Si in a concentration of 10¹⁸ cm⁻³ are stacked on a substrate 1 composed of semi-insulating GaAs. Quantum boxes 4 of not more than 500 Å in size composed of InAs are buried in the barrier layer 3. Ohmic source and drain electrodes 5 and 7 are formed on the barrier layer 3 at a prescribed interval. Further, a Schottky gate electrode 6 is formed on the barrier layer 3 between the source and drain electrodes 5 and 7.

In the semiconductor device according to the first embodiment, the quantum boxes 4 formed in the barrier layer 3 include first, second, third, fourth and fifth quantum boxes 41, 42, 43, 44 and 45, as shown in Fig. 1B. The first to fifth quantum boxes 41 to 45 align with each other on straight lines respectively as shown by broken lines, to form a first quantum box string 41a, a second quantum box string 42a, a third quantum box string 43a, a fourth quantum box string 44a and a fifth quantum box string 45a respectively. The first to fifth quantum box strings 41a to 45a are distributed substantially in parallel with each other at prescribed intervals, in a direction perpendicular to the direction, where electrons transit in a channel region, connecting the source and drain electrodes 5 and 7 with each other.

When the length of the gate electrode 6 is 0.8 µm, for example, seven quantum box strings are formed under the gate electrode 6 so that the average interval Lx between the strings is about 1000 Å, and the average interval Ly between the quantum boxes in each string is about 300 Å. Fig. 1B shows only five quantum box strings 41a to 45a, for simplifying the illustration.

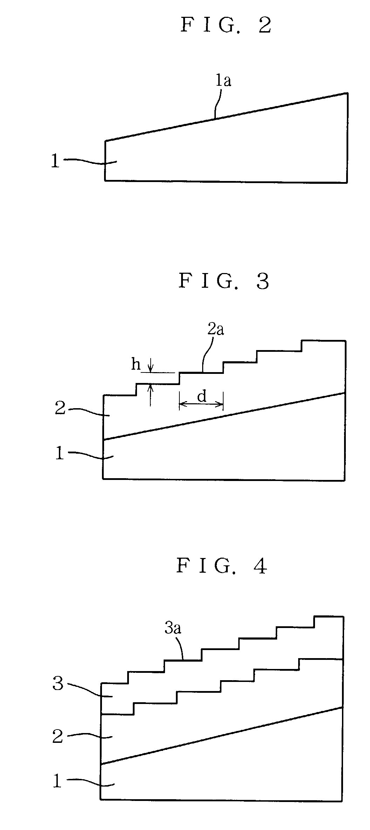

The method of fabricating the semiconductor device according to the first embodiment is now described with reference to Figs. 2 to 8. Figs. 2 to 8 are typical sectional views showing the method of fabricating the semiconductor device.

In the method of fabricating the semiconductor device according to the first embodiment, the substrate 1 composed of semi-insulating GaAs having a surface 1a inclined by about 2° in the [010] direction from the (100) plane is first prepared, as shown in Fig. 2. At this time, steps (single steps; not shown) each having a height corresponding to one GaAs molecular layer appear on the surface 1a of the substrate 1 at irregular intervals.

Then, the channel layer 2 of 8000 Å in thickness composed of GaAs is formed on the surface 1a of the substrate 1, as shown in Fig. 3. This channel layer 2 is formed by epitaxy such as molecular beam epitaxy (MBE), metal-organic chemical vapor deposition (MOCVD) or chemical beam epitaxy (CBE). When this step is completed, surface steps 2a are formed on a surface of the channel layer 2 at regular intervals. The surface steps 2a are multi-steps each having a height of several GaAs molecular layers. In case of employing the substrate 1 having the aforementioned conditions, the distance d between the surface steps 2a is about 1000 Å, and the height h of the surface steps 2a is about 10 Å.

Then, the barrier layer 3 composed of N-AlGaAs is deposited on the surface of the channel layer 2 by about 100 Å through the aforementioned epitaxy, and the deposition of the barrier layer 3 is then interrupted. Surface steps 3a of the barrier layer 3 are multi-steps, similarly to the surface steps 2a of the channel layer 2. In this case, the distance between the surface steps 3a is about 1000 Å, and the height thereof is about 10 Å.

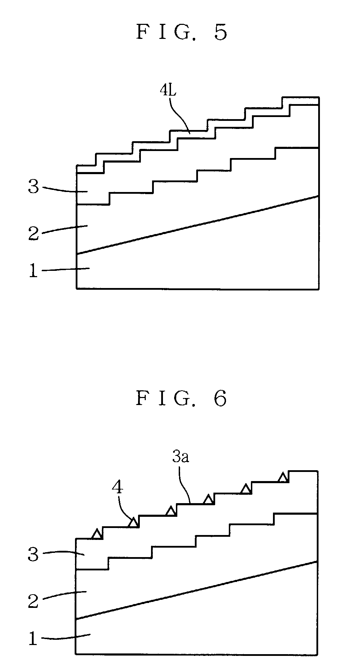

Then, an InAs layer 4A is deposited on the barrier layer 3 by about 2.5 molecular layers in thickness through the aforementioned epitaxy, as shown in Fig. 5. At this time, the InAs layer 4L, having a larger lattice constant than the channel layer 4 and the barrier layer 3, is remarkably distorted in its interior.

Then, the InAs layer 4L is further deposited on the barrier layer 3 by about 2.5 molecular layers including the step shown in Fig. 5 through the aforementioned epitaxy. Thus, the InAs layer 4L, two-dimensionally spreading due to the aforementioned distortion, are transformed into the quantum boxes 4 which are three-dimensional blocks of several 100 Å in size, and these quantum boxes 4 align with each other along the surface steps 3a on the barrier layer 3, as shown in Fig. 6. Such a method of forming quantum boxes through distortion is known as self-organized formation of quantum boxes (refer to Appl. Phys. Lett. 66, p. 3636 (1995)).

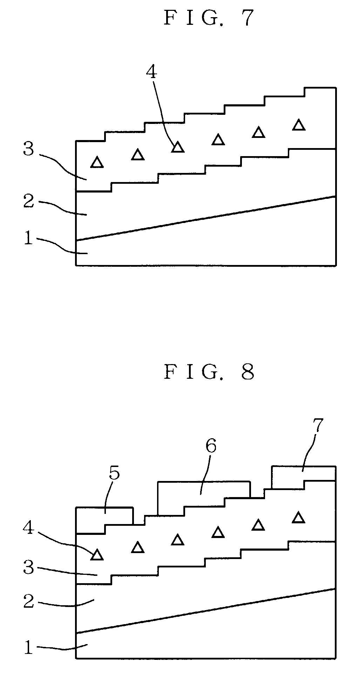

Then, the barrier layer 3 is deposited again to bury the quantum boxes 4 therein through the aforementioned epitaxy, as shown in Fig. 7.

Finally, the ohmic source and drain electrodes 5 and 7 composed of AuGeNi are formed on the barrier layer 3 by vapor deposition, and the Schottky gate electrode 6 composed of TiAl is formed on the barrier layer 3 between the source and drain electrodes 5 and 7. Thus fabricated is the semiconductor device according to the first embodiment.

While Figs. 2 to 8 exaggeratedly illustrate the inclination of the substrate 1 and the surface steps 2a and 3a, the height of each surface step is about 10 Å at the most, for example, and the respective semiconductor layers can be regarded as substantially flat in practice, as shown in Fig. 1A.

The operation characteristics of the semiconductor device according to the first embodiment shown in Figs. 1A and 1B are now described. First, consider that no electrons are present in the quantum boxes 4 shown in Fig. 1A. When a voltage of about 1 V is applied between the source and drain electrodes 5 and 7 in this case, electrons entering the barrier layer 3 from the source electrode 5 go out from the drain electrode 7 through the channel layer 2, to develop a source-to-drain current of about 1 mA. This state corresponds to an erase state of the element.

When a positive pulse voltage of not more than 1 V is applied to the gate electrode 6 in this state, the electrons flowing in the channel layer 2 are confined in the quantum boxes 4 successively from the quantum box string 45a closest to the drain electrode 7, and held as such. Thus, the source-to-drain current reduces. In this case, the number N of the quantum box strings confining the electrons depends on the value of the pulse voltage applied to the gate electrode 6, and the value of the source-to-drain current is decided in correspondence to the number N of the quantum box strings.

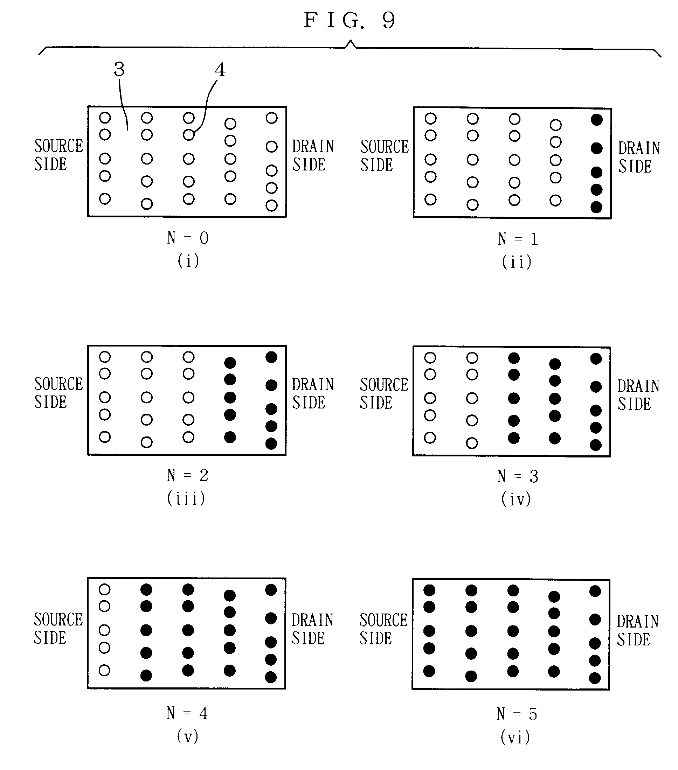

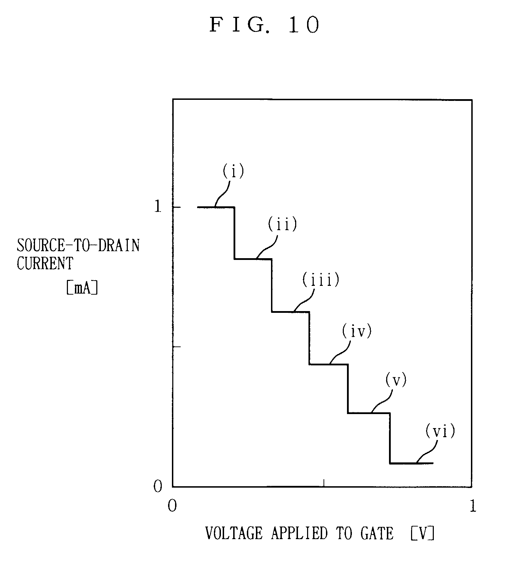

This is now described in detail with reference to Figs. 9 and 10. Fig. 9 shows sectional views identical to that shown in Fig. 1B. Portions identical to those in Fig. 1B are denoted by the same reference numerals, and redundant description is omitted. Referring to Fig. 9, black circles show the quantum boxes confining electrons, and symbol N denotes the number of the quantum box strings confining the electrons. In case Fig. 9, five quantum box strings are provided in total. The electrons are confined in the quantum boxes successively from the string closer to the drain electrode 7 as hereinabove described, and hence six states (i) to (vi) appear in correspondence to the values of the number N of strings.

Fig. 10 is a current-voltage characteristic diagram of the semiconductor device according to the first embodiment having the structure shown in Fig. 1A. Referring to Fig. 10, the vertical axis shows a source-to-drain current flowing when voltages of 0 V and +1 V are applied to the source and drain electrodes 5 and 7 respectively, and the transverse axis shows a positive pulse voltage applied to the gate electrode 6. Numerals (i) to (vi) correspond to the six states (i) to (vi) in Fig. 9 respectively. According to the present invention, the quantum boxes form the quantum box strings at prescribed intervals, whereby the value of the source-to-drain current changes discontinuously, i.e., stepwise.

The state (i) in Figs. 9 and 10 expresses an erase state where no electrons are confined in the quantum box strings. When the positive pulse voltage is applied to the gate electrode 6 in correspondence to the states (ii) to (vi) in Fig. 9, electrons are confined in the quantum box strings, as shown in (ii) to (vi) in Fig. 9. These five states correspond to write states of the element. Namely, five write states of N = 1 to 5 and one erase state of N = 0 are present in the example shown in Figs. 9 and 10.

The electrons are confined in the quantum boxes successively from the quantum box string closest to the drain electrode 7 since the positive voltage applied to the drain electrode 7 is added to that applied to the gate electrode 6 so that the total voltage is applied to the electrons close to the drain electrode 7.

When a negative bias of about 1 V is applied to the gate electrode 6 in any write state, the electrons confined in the quantum box strings enter the channel layer 2 again, and the element returns to the aforementioned erase state.

As hereinabove described, the semiconductor device according to the first embodiment of the present invention operates as a multivalued logic digital memory element in which a source-to-drain current discontinuously changes in a multi-step manner, as shown in Figs. 9 and 10.

While the operation of the above embodiment has been described with reference to five quantum box strings, the semiconductor device may alternatively be provided with three or seven quantum box strings, to serve as a 2- or 3-bit digital memory element.

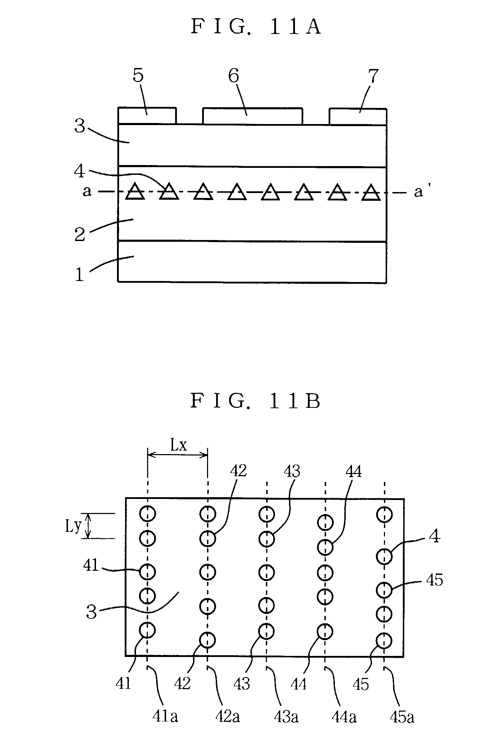

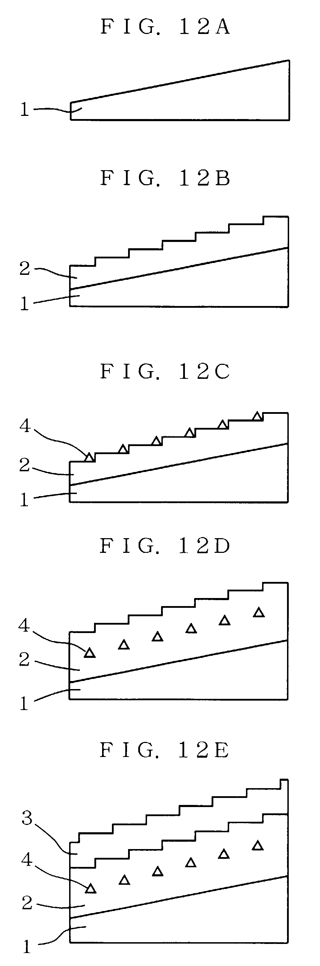

With reference to Figs. 11A and 11B and 12A to 12E, the structure of a semiconductor device according to a second embodiment of the present invention and a method of fabricating the same are now described.

Fig. 11A is a typical sectional view showing the structure of the semiconductor device according to the second embodiment of the present invention, and Fig. 11B is a sectional view of the semiconductor device taken along the line a - a' in Fig. 11A showing the section along the one-dot chain line a - a' as viewed from above. Portions identical to those in Figs. 1A and 1B are denoted by the same reference numerals, and redundant description is omitted.

In the semiconductor device according to the second embodiment, quantum boxes 4 are buried in a channel layer 2. For example, the quantum boxes 4 are positioned at a distance of about 200 Å from a hetero-interface formed by the channel layer 2 and a barrier layer 3, for example.

The method of fabricating the semiconductor device according to the second embodiment is now described with reference to Figs. 12A to 12E. Figs. 12A to 12E illustrate the semiconductor device as viewed from a section thereof. Portions identical to those in Figs. 2 to 8 are denoted by the same reference numerals, and redundant description is omitted.

Steps shown in Figs. 12A and 12B are identical to those in Figs. 2 and 3. Then, the channel layer 2 is deposited in a step identical to that in Fig. 3, and the growth of the channel layer 2 is interrupted in an intermediate stage, to form the quantum boxes 4. The quantum boxes 4 are formed similarly to the aforementioned case of Figs. 5 and 6.

Then, the channel layer 2 is further deposited by about 200 Å in thickness to bury the quantum boxes 4 therein, as shown in Fig. 12D. Then, the barrier layer 3 is formed on the channel layer 2, as shown in Fig. 12E. Finally, a source electrode 5, a gate electrode 6 and a drain electrode 7 are formed on the barrier layer 3 respectively, similarly to the step shown in Fig. 8.

The semiconductor device according to the second embodiment operates as a multivalued logic digital memory element in which a source-to-drain current discontinuously changes in correspondence to the value of a gate pulse voltage, similarly to the semiconductor device according to the first embodiment.

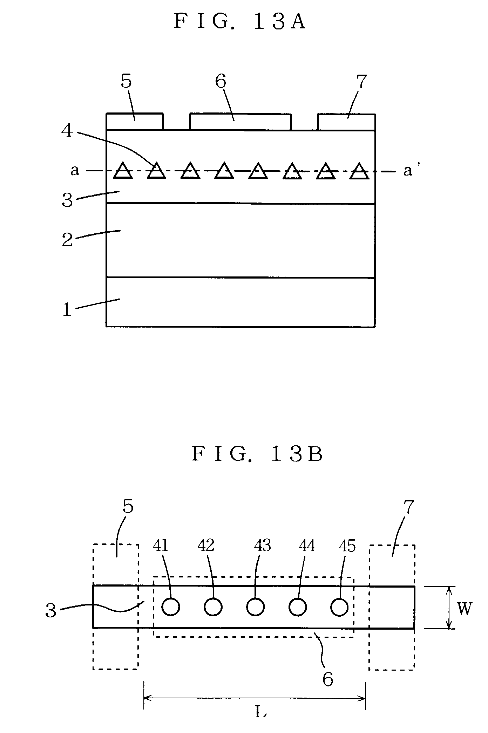

The structure of a semiconductor device according to a third embodiment of the present invention and a method of fabricating the same are now described with reference to Figs. 13A to 18B.

Fig. 13A is a typical sectional view showing the structure of the semiconductor device according to the third embodiment, and Fig. 13B is a sectional view of the semiconductor device taken along the line a - a' in Fig. 13A showing the section along the one-dot chain line a - a' as viewed from above. Portions identical to those in Figs. 1A and 1B are denoted by the same reference numerals, and redundant description is omitted. Fig. 13B illustrates only the section of a barrier layer 3 taken along the line a - a' and electrode positions (broken lines), and omits the remaining portions.

In the semiconductor device according to the third embodiment, a channel is formed as a thin line having a width W, which longitudinally extends in a direction connecting source and drain electrodes 5 and 7 with each other as shown in Fig. 13B, and a first quantum box 41, a second quantum box 42, a third quantum box 43, a fourth quantum box 44 and a fifth quantum box 45 are arranged in a barrier layer 3 provided on the thin-line channel to align with each other one by one substantially at regular intervals. The thin-line channel has the channel width W sufficiently smaller than its channel length L. For example, the channel width W is not more than 1000 Å, and the channel length L is not more than 1 µm.

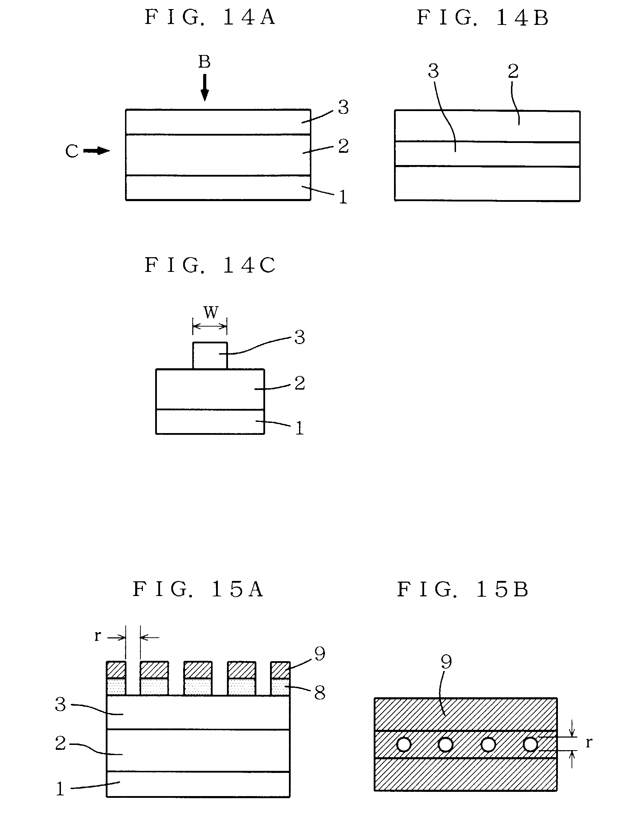

Figs. 14A to 18B illustrate the method of fabricating the semiconductor device according to the third embodiment of the present invention. Fig. 14A is a sectional view as viewed in the same direction as Fig. 13A, Fig. 14B is a top plan view as viewed along arrow B in Fig. 14A, and Fig. 14C is a side elevational view as viewed along arrow C in Fig. 14A. Figs. 15A to 18A are sectional views, and Figs. 15B to 18B are top plan views respectively.

In the step shown in Figs. 14A and 14B, a channel layer 2 and the barrier layer 3 are formed on a substrate 1 similarly to the steps shown in Figs. 2 to 4, and thereafter the barrier layer 3 is worked into the form of a thin line having a width of about 1000 Å by electron beam (EB) lithography and reactive plasma etching (RIE), as shown in Fig. 14C. According to the third embodiment, a surface of the substrate 1 may not be inclined from the (001) plane.

As shown in Figs. 15A and 15B, an SiO₂ film 8 and a resist film 9 are stacked on the thin-line barrier layer 3 formed in the step shown in Figs. 14A, 14B and 14C, and cylindrical patterns of a diameter r are formed through the aforementioned EB lithography and RIE. At this time, the diameter r is set to be not more than 500 Å.

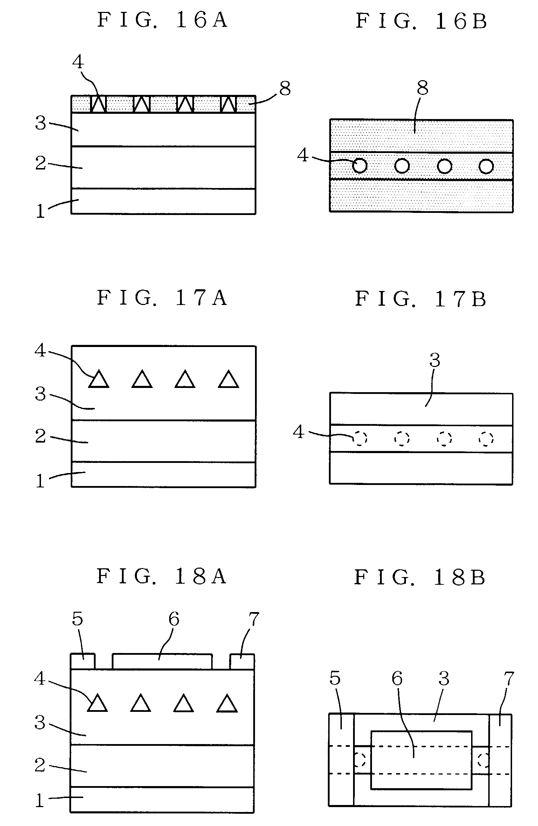

As shown in Figs. 16A and 16B, the resist film 9 is removed and quantum boxes 4 are formed by the aforementioned epitaxy. At this time, no semiconductor grows on the SiO₂ film 8, whereby the quantum boxes 4 are selectively formed in the aforementioned cylindrical patterns.

Then, the SiO₂ film 8 is removed, and thereafter the barrier layer 3 is further deposited to bury the quantum boxes 4 therein through the aforementioned epitaxy, as shown in Figs. 17A and 17B.

Finally, the source electrode 5, the gate electrode 6 and the drain electrode 7 are formed on the barrier layer 3, as shown in Figs. 18A and 18B.

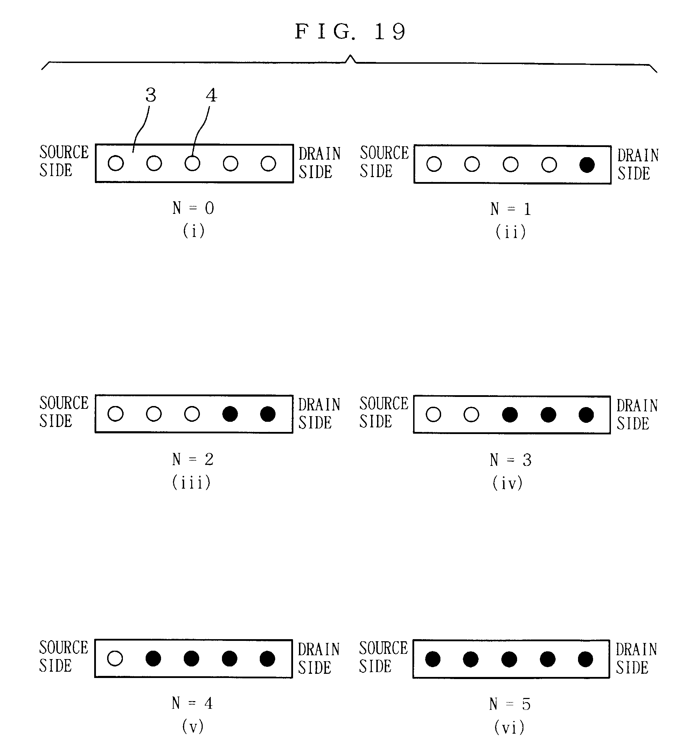

The operation of the semiconductor device according to the third embodiment is now described with reference to Fig. 19. Fig. 19 shows sectional views similar to that of the third embodiment shown in Fig. 13B. Portions identical to those in Fig. 13B are denoted by the same reference numerals, and redundant description is omitted.

Five quantum boxes 4 are formed in Fig. 19. Similarly to Fig. 9, black circles show quantum boxes confining electrons, and symbol N denotes the number of the quantum boxes confining electrons. The electrons are confined successively from the quantum box 4 closest to the drain electrode 7 similarly to the aforementioned first embodiment, and hence six states (i) to (vi) take place in correspondence to the values of the number N. The semiconductor device according to the third embodiment operates as a multivalued logic digital memory element in which a source-to-drain current discontinuously changes in response to the values of a gate pulse voltage corresponding to the six states, similarly to the semiconductor device according to the first embodiment.

While the quantum boxes 4 are formed in the thin-line barrier layer 3 according to the third embodiment, the channel layer 2 may alternatively be worked into a thin line, so that the quantum boxes 4 are formed in the channel layer 2 similarly to the second embodiment. Also in this case, the semiconductor device operates as a multivalued logic digital memory element in which a source-to-drain current discontinuously changes in correspondence to the values of the gate pulse voltage.

While the substrate 1 is formed of a GaAs (100) substrate in each of the aforementioned first to third embodiments, the same may alternatively be formed of a GaAs (111) substrate or a GaAs (311) substrate. Further alternatively, the substrate 1 may be formed of an InP or Si substrate, and the materials for the channel layer 2, the barrier layer 3 and the quantum boxes 4 may be prepared from InGaAs or SiGe, InAlAs or Si, and InAs or Ge respectively.

In addition, the materials for the barrier layer 3 and the quantum boxes 4 may be prepared from an insulator such as SiN or SiO₂ and a metal such as poly-Si or Au respectively.

While the ohmic electrodes (the source and drain electrodes 5 and 7) are formed on the barrier layer 3 in each of the aforementioned first to third embodiments, a high concentration layer composed of Si-doped n⁺-GaAs, for example, may be stacked on the barrier layer 3, so that the ohmic electrodes are formed on the high concentration layer.

While the barrier layer 3 is formed on the channel layer 2 and the electrodes 5, 6 and 7 are formed on the barrier layer 3 in each of the aforementioned first to third embodiments, the order of stacking may be so changed that the channel layer 2 is formed on the barrier layer 3 and the electrodes 5, 6 and 7 are formed on the channel layer 2. Further, a high concentration layer composed of Si-doped n⁺-GaAs, for example, may be formed on the channel layer 2, so that the ohmic electrodes are formed on the high concentration layer.

While each of the aforementioned first to third embodiments is provided with the gate electrode 6 for controlling the write/erase state of the element, the gate electrode 6 may be so omitted that a positive pulse voltage is applied to the drain electrode 7 and light is applied between the source and drain electrodes 5 and 7 thereby controlling the write/erase state.

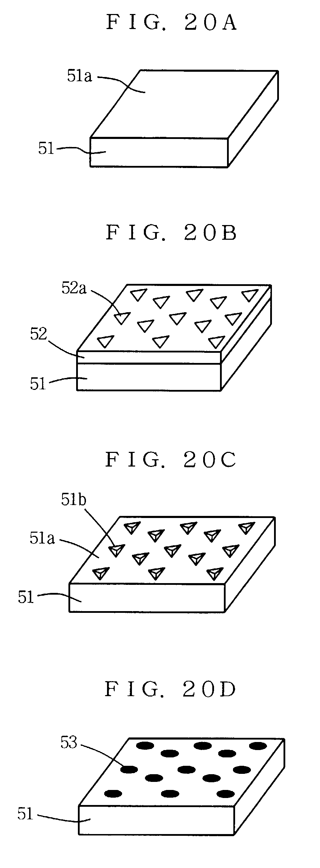

A method of fabricating quantum boxes according to a fourth embodiment of the present invention is now described. Figs. 20A, 20B, 20C and 20D are perspective views showing the method of fabricating quantum boxes according to the fourth embodiment. Referring to Fig. 20A, numeral 51 denotes a substrate composed of GaAs or a semiconductor layer stacked on the substrate, which is hereinafter referred to as a semiconductor layer 51. A surface 51a of this semiconductor layer 51, composed of the GaAs (221) plane, hardly allows self-organized formation of quantum boxes.

Then, a resist 52 is applied onto the semiconductor layer 51, and thereafter hole resist patterns 52a of about 1000 Å in size are formed by electron beam (EB) lithography, for exposing the surface 51a of the semiconductor layer 51 on bottom portions of the resist patterns 52a. The surface concentration of the resist patterns 52a is about 10¹¹ to 10¹²/cm², depending on the application. While Fig. 20B shows triangular resist patterns 52a, these resist patterns 52a may have another shape such as a circular or rectangular shape.

In the state shown in Fig. 20B, the surface 51a of the semiconductor layer 51 exposed on the bottoms of the resist patterns 52a are etched with a mixed solution of citric acid and hydrogen peroxide, for forming etching patterns 51b having surfaces, formed by a plane other than the GaAs (221) plane, readily allowing self-organized formation of quantum boxes. Then, the resist 52 is removed, whereby the etching patterns 51b having the surfaces readily allowing self-organized formation of quantum boxes appear on the surface 51a of the semiconductor layer 51, as shown in Fig. 20C.

The etching patterns 51b may be at a depth developing the plane other than the GaAs (221) plane, and this depth is not particularly restricted.

The GaAs (221) plane most hardly allows self-organized formation of quantum boxes, composed of InAs as described later, as compared with the (100), (110) and (111) planes and the like, and hence the etching patterns 51b may have any plane other than the GaAs (221) plane, and this plane is not particularly restricted.

Finally, an InAs layer is formed on the surface 51a of the semiconductor layer 51 having the etching patterns 51b. The surface 51a of the semiconductor layer 51 hardly allows self-organized formation of quantum boxes composed of InAs, and hence quantum boxes 53 composed of InAs are selectively formed on the etching patterns 51b, as shown in Fig. 20D.

At this time, the quantum boxes 53 are formed in a self-organized manner, and hence the size thereof is not more than several 100 Å, regardless of the size of the etching patterns 51b.

The quantum boxes 53 composed of InAs are formed by epitaxy such as molecular beam epitaxy (MBE), metal-organic chemical vapor deposition (MOCVD) or chemical beam epitaxy (CBE).

A method of fabricating quantum boxes according to a fifth embodiment of the present invention is now described. The method according to the fifth embodiment utilizes steps similar to those of the method according to the fourth embodiment shown in Figs. 20A and 20D, and hence steps of forming resist patterns 52a and etching patterns 51b corresponding to those in Figs. 20B and 20C are mainly described.

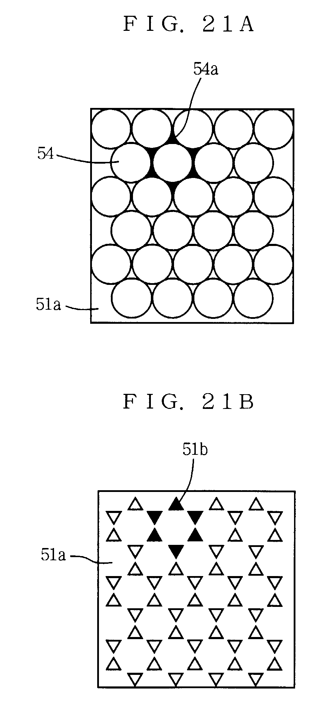

Figs. 21A and 21B are top plan views showing the method of fabricating quantum boxes according to the fifth embodiment. Similarly to the step shown in Fig. 20A, colloidal polystyrene is applied onto a surface 51a of a semiconductor layer formed by the GaAs (221) plane hardly allowing self-organized formation by a spinner, whereby molecular balls 54 composed of polystyrene regularly align with each other on the surface 51a, as shown in Fig. 21A. The molecular balls 54 are about 3200 Å in diameter.

At this time, the clearances between the molecular balls 54 define triangular patterns 54a, and the surface 51a of the semiconductor layer is exposed on bottom portions of the triangular patterns 54a, as shown in Fig. 21A. The size of each edge of the triangular patterns 54a is 660 Å.

Such a method of forming regular patterns by simply applying a polymer with no lithography with ultraviolet rays, X-rays, electron beams or ion beams is known as natural lithography.

The aforementioned molecular balls 54 of polystyrene are employed as resist masks for etching the surface 51a of the semiconductor layer with the aforementioned citric acid, and thereafter the molecular balls 54 of polystyrene are removed. Thus, the etching patterns 51b having surfaces readily allowing self-organized formation of quantum boxes are formed as shown in Fig. 21B.

Finally, an InAs layer is formed on the semiconductor layer through the aforementioned epitaxy, similarly to the step shown in Fig. 20D. Thus, quantum boxes of not more than several 100 Å in size composed of InAs are selectively formed on the etching patterns 51b.

The fifth embodiment requires no lithography with ultraviolet rays, X-rays, electron beams, ion beams or the like, whereby the throughput can be improved and the cost can be reduced in fabrication of a semiconductor device.

Each of the methods of fabricating quantum boxes according to the fourth and fifth embodiments can be employed for forming the quantum boxes of the semiconductor device according to any of the first to third embodiments.

While the surface 51a of the semiconductor layer 51 is prepared from the GaAs (221) plane in each of the methods according to the fourth and fifth embodiments, the surface 51a may alternatively be prepared from the (221) plane of InGaAs or AlGaAs.

While the quantum boxes 53 are prepared from InAs, a material such as InGaAs, InSb, GaSb or a combination of these elements is also employable.

While the etching patterns 51b are formed through citric acid in each of the methods according to the fourth and fifth embodiments, another anisotropic etchant such as tartaric acid is also employable.

While polystyrene is employed for natural lithography in the method according to the fifth embodiment, a method of arranging Au clusters is also employable.

Although the present invention has been described and illustrated in detail, it is clearly understood that the same is by way of illustration and example only and is not to be taken by way of limitation.

While the cases in which electrons are employed as carriers are described in the above first to fifth embodiments, the present invention can be applied to the cases in which holes are employed as carriers. In these cases, a p-type barrier layer doped with a p-type dopant such as Be or C may be formed.

## Claims

1. A semiconductor device comprising:
a channel region where carriers transit; and
a plurality of quantum boxes provided in the vicinity of said channel region through a potential barrier for storing carriers,
said plurality of quantum boxes being arranged at prescribed intervals in a direction parallel to the carrier transition direction in said channel region.

2. The semiconductor device in accordance with claim 1, wherein
said plurality of quantum boxes form a plurality of quantum box strings perpendicular to the carrier transition direction in said channel region,
said plurality of quantum box strings being arranged at said prescribed intervals in said direction parallel to the carrier transition direction in said channel region.

3. The semiconductor device in accordance with claim 1, wherein
said channel region is formed in the shape of a thin line parallel to the carrier transition direction in said channel region,
said plurality of quantum boxes being arranged in a line at said prescribed intervals along said thin-line shaped channel region.

4. The semiconductor device in accordance with claim 1, further comprising first and second electrodes for supplying carriers to said channel region.

5. The semiconductor device in accordance with claim 4, further comprising a third electrode for generating an electric field between said channel region and said plurality of quantum boxes.

6. A semiconductor device comprising:
a channel layer having a channel region where carriers transit in a direction parallel to a layer interface;
a barrier layer being formed on said channel layer and having a larger forbidden bandwidth than said channel layer; and
a plurality of quantum boxes being buried in said barrier layer and having a smaller forbidden bandwidth than said barrier layer,
said plurality of quantum boxes being arranged at prescribed intervals in a direction parallel to the carrier transition direction in said channel region.

7. The semiconductor device in accordance with claim 6, wherein
said plurality of quantum boxes form a plurality of quantum box strings being perpendicular to the carrier transition direction in said channel region,
said plurality of quantum box strings being arranged at said prescribed intervals in said direction perpendicular to the carrier transition direction in said channel region.

8. The semiconductor device in accordance with claim 6, wherein
said channel region is formed in the shape of a thin line being parallel to the carrier transition direction in said channel region,
said plurality of quantum boxes being arranged in a thin-line shaped region of said barrier layer corresponding to said thin-line shaped channel region in a line at said prescribed intervals along said direction parallel to the carrier transition direction in said channel region.

9. The semiconductor device in accordance with claim 6, wherein
said channel layer is formed of an undoped semiconductor,
said barrier layer is formed of one conductivity type semiconductor or insulator, and
said plurality of quantum boxes are composed of an undoped semiconductor or metal.

10. The semiconductor device in accordance with claim 6, further comprising first and second electrodes for supplying carriers to said channel region.

11. The semiconductor device in accordance with claim 10, further comprising a third electrode for generating an electric field between said channel region and said plurality of quantum boxes.

12. The semiconductor device in accordance with claim 10, wherein
an output is extracted as multivalued logic from said first and second electrodes in correspondence to presence/absence of carriers in said plurality of quantum boxes.

13. The semiconductor device in accordance with claim 6, wherein
said channel layer is formed of a GaAs, InGaAs or SiGe semiconductor, said barrier layer is formed of an AlGaAs, InAlAs or Si semiconductor, and said plurality of quantum boxes are composed of an InAs or Ge semiconductor.

14. The semiconductor device in accordance with claim 6, further comprising a substrate having a slightly inclined surface being inclined from the basic plane orientation,
said channel layer being formed on said slightly inclined surface of said substrate.

15. A semiconductor device comprising:
a channel layer having a channel region where carriers transit in a direction parallel to a layer interface;
a barrier layer being formed on said channel layer and having a larger forbidden bandwidth than said channel layer; and
a plurality of quantum boxes being buried in said channel layer and having a smaller forbidden bandwidth than said channel layer,
said plurality of quantum boxes being arranged at prescribed intervals in a direction parallel to the carrier transition direction in said channel region.

16. The semiconductor device in accordance with claim 15, wherein
said plurality of quantum boxes form a plurality of quantum box strings being perpendicular to the carrier transition direction in said channel region,
said plurality of quantum box strings being arranged at said prescribed intervals in said direction parallel to the carrier transition direction in said channel region.

17. The semiconductor device in accordance with claim 15, wherein
said channel region is formed in the shape of a thin line being parallel to the carrier transition direction in said channel region,
said plurality of quantum box strings being arranged in a line at said prescribed intervals along said direction parallel to the carrier transition direction in said thin-line shaped channel region.

18. The semiconductor device in accordance with claim 15, wherein
said channel layer is formed of an undoped semiconductor,
said barrier layer is formed of one conductivity type semiconductor or insulator, and
said plurality of quantum boxes are composed of an undoped semiconductor or metal.

19. The semiconductor device in accordance with claim 15, further comprising first and second electrodes for supplying carriers to said channel region.

20. The semiconductor device in accordance with claim 19, further comprising a third electrode for generating an electric field between said channel region and said plurality of quantum boxes.

21. The semiconductor device in accordance with claim 19, wherein
an output is extracted as multivalued logic from said first and second electrodes in correspondence to presence/absence of carriers in said plurality of quantum boxes.

22. The semiconductor device in accordance with claim 15, wherein
said channel layer is formed of a GaAs, InGaAs or SiGe semiconductor, said barrier layer is formed of an AlGaAs, InAlAs or Si semiconductor, and said plurality of quantum boxes are composed of an InAs or Ge semiconductor.

23. The semiconductor device in accordance with claim 15, further comprising a substrate having a slightly inclined surface being inclined from the basic plane orientation,
said channel layer being formed on said slightly inclined surface of said substrate.

24. A semiconductor memory device comprising:
a channel region where carriers transit;
a plurality of quantum boxes being provided in the vicinity of said channel region through a potential barrier for storing carriers; and
first and second electrodes for supplying carriers to said channel region,
said plurality of quantum boxes being arranged at prescribed intervals in a direction parallel to the carrier transition direction in said channel region.

25. The semiconductor memory device in accordance with claim 24, wherein
an output is extracted as multivalued logic from said first and second electrodes in correspondence to presence/absence of carriers in said plurality of quantum boxes.

26. A method of fabricating a semiconductor device comprising a channel region where carriers transit, and a plurality of quantum boxes being provided in the vicinity of said channel region through a potential barrier for storing carriers, said method comprising steps of:
forming a single or plurality of semiconductor layers including said channel region;
interrupting formation of said single or plurality of semiconductor layers;
forming a plurality of quantum boxes on surfaces of said single or plurality of semiconductor layers appearing during said interruption at prescribed intervals in a direction parallel to the carrier transition direction in said channel region; and
further forming a semiconductor layer on said single or plurality of semiconductor layers to bury said plurality of quantum boxes therein.

27. The method of fabricating a semiconductor device in accordance with claim 26, further comprising a step of forming a slightly inclined surface having a plane orientation inclined from the basic crystal orientation on a surface of a substrate,
said step of forming said single or plurality of semiconductor layers including a step of forming said single or plurality of semiconductor layers including said channel region on said slightly inclined surface of said substrate.

28. The method of fabricating a semiconductor device in accordance with claim 27, wherein
said step of forming said plurality of quantum boxes includes a step of forming said plurality of quantum boxes by self-organized formation so that said plurality of quantum boxes align with each other along a surface step appearing on said surface of said semiconductor layer during said interruption.

29. The method of fabricating a semiconductor device in accordance with claim 26, wherein
said single or plurality of semiconductor layers include a first semiconductor having a surface having a plane orientation hardly allowing self-organized formation,
said step of forming said plurality of quantum boxes including steps of:
forming a plurality of patterns having a plane orientation readily allowing self-organized formation on said surface of said first semiconductor, and
forming a plurality of quantum boxes composed of a second semiconductor on said plurality of patterns in a self-organized manner by forming said second semiconductor on said surface of said first semiconductor.

30. A method of fabricating a semiconductor device comprising a channel region where carriers transit, a plurality of quantum boxes being provided in the vicinity of said channel region through a potential barrier for storing carriers, and a buried layer, formed of a semiconductor or insulator, burying said plurality of quantum boxes therein, said method comprising steps of:
forming a thin-line region by working at least one of said channel region and said buried layer into a thin line;
forming a plurality of quantum boxes on said thin-line region at prescribed intervals; and
burying said plurality of quantum boxes in a semiconductor or insulator.

31. The method of fabricating a semiconductor device in accordance with claim 30, further comprising a step of forming an electrode to be opposed to said plurality of quantum boxes.

32. The method of fabricating a semiconductor device in accordance with claim 30, wherein
said single or plurality of semiconductor layers include a first semiconductor having a surface having a plane orientation hardly allowing self-organized formation,
said step of forming said plurality of quantum boxes including steps of:
forming a plurality of patterns having a plane orientation readily allowing self-organized formation on said surface of said first semiconductor, and
forming a plurality of quantum boxes composed of a second semiconductor on said plurality of patterns in a self-organized manner by forming said second semiconductor on said surface of said first semiconductor.

33. A method of fabricating a semiconductor device, comprising steps of:
forming a slightly inclined surface having a plane orientation inclined from the basic crystal orientation on a surface of a substrate;
forming a semiconductor layer on said slightly inclined surface of said substrate;
interrupting said formation of said semiconductor layer; and
forming a plurality of quantum boxes by self-organized formation so that said plurality of quantum boxes align with each other along a surface step appearing on a surface of said semiconductor layer during said interruption.

34. A method of fabricating a semiconductor device, comprising steps of:
forming a pattern having a plane orientation readily allowing self-organized formation on a surface of a first semiconductor having a plane orientation hardly allowing self-organized formation; and
forming a quantum box composed of a second semiconductor on said pattern in a self-organized manner by forming said second semiconductor on said surface of said first semiconductor.

35. The method of fabricating a semiconductor device in accordance with claim 34, wherein
said step of forming said pattern includes a step of employing natural lithography.

36. The method of fabricating a semiconductor device in accordance with claim 35, wherein
said natural lithography includes steps of:
applying a polymer compound to said surface of said first semiconductor thereby arranging molecular balls of said polymer compound on said surface of said first semiconductor, and
etching said first semiconductor through said molecular balls of said polymer compound serving as masks.

37. The method of fabricating a semiconductor device in accordance with claim 34, wherein
said plane orientation hardly allowing self-organized formation is the (221) plane, and said plane orientation readily allowing self-organized formation is a plane different from the (221) plane.

38. The method of fabricating a semiconductor device in accordance with claim 34, wherein
said first semiconductor includes a single or plurality of semiconductors selected from a group of GaAs, AlGaAs and InGaAs semiconductors, and said quantum box is composed of a single or plurality of semiconductors selected from a group of InAs, InGaAs, InSb and GaSb semiconductors.
